# EUROPÄISCHE PATENTSCHRIFT

(11) **EP 1 597 780 B1**
(45) Veröffentlichungstag und Bekanntmachung des Hinweises auf die Patenterteilung: **06.10.2010**
(21) Anmeldenummer: 04712473.0
(22) Anmeldetag: 19.02.2004
(51) Int. Cl.: H01L 41/083

(54) **ELEKTRISCHES VIELSCHICHTBAUELEMENT UND SCHICHTSTAPEL**
ELECTRICAL MULTILAYERED COMPONENT AND LAYER STACK
COMPOSANT ELECTRIQUE MULTICOUCHE ET EMPILEMENT DE COUCHES

(30) Priorität: 24.02.2003 DE 10307825
(43) Veröffentlichungstag der Anmeldung: 23.11.2005
(73) Patentinhaber: EPCOS AG, 81669 München (DE)
(72) Erfinder: RAGOSSNIG, Heinz, 9360 Friesach (AT); RAGOSSNIG, Sigrid, 9360 Friesach (AT)
(74) Vertreter: Epping - Hermann - Fischer
(86) Internationale Anmeldenummer: PCT/DE2004/000313
(87) Internationale Veröffentlichungsnummer: WO 2004/077583

(56) Entgegenhaltungen:
- EP-A- 1 204 152
- WO-A-03/105246
- DE-A- 4 029 972
- US-A- 5 835 338
- PATENT ABSTRACTS OF JAPAN Bd. 014, Nr. 411 (E-0973), 5. September 1990 (1990-09-05) -& JP 02 155211 A (MATSUSHITA ELECTRIC IND CO LTD), 14. Juni 1990 (1990-06-14)

## Beschreibung

Die Erfindung betrifft ein elektrisches Vielschichtbauelement mit übereinanderliegenden keramischen Schichten und dazwischenliegenden Elektrodenschichten. Ferner betrifft die Erfindung einen Schichtstapel.

Es sind Piezoaktoren bekannt, bei denen in einem Stapel übereinanderliegende piezokeramische Schichten angeordnet sind. Zwischen den keramischen Schichten sind Innenelektroden angeordnet. Durch Anlegen einer äußeren Spannung an jeweils zwei gegenüberliegende Elektrodenschichten kann aufgrund des resultierenden elektrischen Feldes die keramische Schicht durch den piezoelektrischen Effekt zu einer kleinen Auslenkung gebracht werden. Die Auslenkungen der übereinanderliegenden keramischen Schichten addieren sich in Längsrichtung.

Um bei den Piezoaktoren die Außenkontaktierung der Innenelektroden mit einfachen Mitteln durchführen zu können, ist es üblicherweise vorgesehen, daß am Rand des Piezoaktors in einer sogenannten passiven Zone nur jeweils dem gleichen elektrischen Pol zugeordnete Innenelektroden übereinanderliegen. Die dem anderen elektrischen Pol zugeordneten Innenelektroden verlaufen an dieser Stelle nicht bis ganz zum Rand des Aktors, sondern sie sind auf eine Fläche im Innern des Aktors begrenzt. Im Gegensatz zur aktiven Zone, d.h. zu der Zone, wo Elektrodenschichten unterschiedlicher Polarität einander gegenüberliegen, findet in der passiven Zone bei Anlegen einer elektrischen Spannung fast keine Ausdehnung der piezoelektrischen Schichten statt, was im Randgebiet der passiven Zone zu einer Zugbelastung der passiven Zone, hervorgerufen durch die aktive Zone, führt. Je mehr piezoelektrische Schichten übereinanderliegen und je größer die angelegte elektrische Spannung ist, um so größer sind auch die am Rand der passiven Zone auftretenden Zugspannungen.

Diese Zugspannungen können im Randbereich der Piezoaktoren zu einer Rißbildung führen, entweder im Betrieb des Piezoaktors oder bereits beim Polen, d.h., bei dem ersten Verfahrensschritt zum Betrieb des Piezoaktors, wo eine elektrische Polarisierung in den piezoelektrischen Schichten erzeugt wird. Diese Risse können im Dauerbetrieb des Piezoaktors sich ins Innere des Aktors fortsetzen und dabei im aktiven Bereich eine oder mehrere Innenelektroden durchbrechen. In der Folge kommt es dann an diesen Bruchstellen zu einem dielektrischen Durchbruch, Schlackenbildung und gegebenenfalls sogar zu einem inneren Kurzschluß im Bauelement. Es ist angestrebt, solche Risse in den Innenelektroden zu vermeiden.

Zur Vermeidung der Risse ist es aus der Druckschrift 199 28 178 A1 bekannt, den Piezoaktor in mehrere Teilaktoren zu unterteilen, wobei die Teilaktoren nach ihrer Herstellung übereinandergestapelt und durch eine Klebung miteinander verbunden werden. Zugspannungen an der inneren Grenze der passiven Zone können sich nun nicht mehr über die gesamte Höhe des Piezoaktors aufaddieren, sondern es sind vielmehr nur noch diejenigen Zugspannungen von Bedeutung, die innerhalb eines Teilaktors entstehen. Diese sind jedoch relativ gering, da ein Teilaktor nur eine sehr geringe Anzahl von piezoelektrischen übereinanderliegenden Schichten aufweist.

Die in dieser Druckschrift beschriebene Vorgehensweise hat den Nachteil, daß die geometrische Präzision beim Übereinanderstapeln mehrerer Einzelaktoren nur sehr gering ist. Darüber hinaus bedeutet das Übereinanderstapeln mehrerer Teilaktoren einen weiteren Schritt in der Herstellung, wodurch zusätzliche Kosten entstehen.

Zur Vermeidung von Rissen in Innenelektroden von Piezoaktoren ist es des weiteren aus der Druckschrift DE 198 02 302 bekannt, die passive Zone durch eine um jeweils 90° versetzte Aufbaureihenfolge über den gesamten Umfang des Piezoaktors zu verteilen. Dieser Aufbau hat jedoch den Nachteil, daß sich die Außenkontaktierung aufwendig gestaltet, da der Piezoaktor von allen vier Außenseiten her kontaktiert werden muß.

Des weiteren ist es aus der Druckschrift DE 100 16 428 A1 bekannt, die Höhe der Innenelektrodenbedruckung an der Stelle der passiven Zone durch zusätzlich angebrachte isolierende Ausgleichschichten in der passiven Zone auszugleichen. Dieser Aufbau hat den Nachteil eines erhöhten Herstellungsaufwandes für den Piezoaktor.

Aus den Druckschriften JP 2 155211 A und WO 03/105246 A2 sind elektrische Vielschichtbauelemente bekannt, wobei in letzterer Rissquellen im Stapelaufbau etwa durch eine Schicht mit organischen Partikeln, die beim Sintern ausbrennen, realisiert werden.

Es ist daher Aufgabe der vorliegenden Erfindung, ein elektrisches Vielschichtbauelement anzugeben, bei dem die Gefahr der Rißbildung der Innenelektroden auf einfache Art und Weise vermindert werden kann.

Diese Aufgabe wird gelöst durch ein elektrisches Vielschichtbauelement nach Patentanspruch 1. Vorteilhafte Ausgestaltungen des Vielschichtbauelements sowie ein Schichtstapel sind den weiteren Patentansprüchen zu entnehmen.

Es wird ein elektrisches Vielschichtbauelement angegeben, das eine Vielzahl von übereinanderliegenden Keramikschichten aufweist. Die Keramikschichten sind entlang einer Längsachse angeordnet. Zwischen den keramischen Schichten sind Elektrodenschichten angeordnet. Des weiteren ist wenigstens an einer Stelle der Längsachse zwischen keramischen Schichten eine keramische Sollbruchschicht angeordnet. Die Sollbruchschicht weist gegenüber Zugspannungen in Längsrichtung eine geringere Stabilität auf als die keramischen Schichten.

Das Vielschichtbauelement hat den Vorteil, daß innerhalb des Bauelements senkrecht zur Längsrichtung entstehende Risse bevorzugt in den Sollbruchschichten geführt werden, da hier die Stabilität gegenüber Zugspannungen am geringsten ist. Damit ist eine kontrollierte Ausbreitung von Rissen entlang der Sollbruchschichten verknüpft, wodurch gleichzeitig ein Reißen der Elektrodenschichten wirksam vermindert werden kann.

Erfindungsgemäß wird die verminderte Stabilität der Sollbruchschichten dadurch erreicht, daß sie gegenüber den keramischen Schichten eine höhere Porosität aufweisen.

Vorzugsweise wird das Bauelement durch Sintern eines Stapels von übereinanderliegenden keramischen Grünfolien und dazwischenliegenden Elektrodenschichten hergestellt. Dadurch entsteht ein monolithisches Bauelement, das einfach und billig herzustellen ist und das für die weiteren Bearbeitungsschritte eine ausreichende mechanische Stabilität besitzt.

Um die maximale Belastung des Bauelements durch in Längsrichtung verlaufende Zugspannungen weiter zu reduzieren, kann es vorgesehen sein, daß an mehreren Stellen der Längsachse Sollbruchschichten vorgesehen sind. Dadurch wird gewissermaßen das Bauelement entlang der Sollbruchschichten in mehrere Teil-Bauelemente unterteilt, wobei jedes Teil-Bauelement hinsichtlich der Belastung durch die Zugspannungen separat zu betrachten ist. Es können sich nicht mehr über die gesamte Länge des Bauelements Zugspannungen aufaddieren und somit zu unkontrollierten Rissen in dem Bauelement führen.

Poröse Schichten in einem keramischen Vielschichtbauelement stellen eine potentielle Schwachstelle dar, insbesondere im Hinblick auf von außen in das Bauelement durch die Poren eindringende Flüssigkeiten und Gase. Es ist daher vorteilhaft, wenn die Sollbruchschichten beim Betrieb des Bauelements weitgehend frei von elektrischen Feldern gehalten werden, um unerwünschte Migrationseffekte zu vermeiden. Dies wird dadurch erreicht, daß die unmittelbar zu einer Sollbruchschicht benachbarten Elektrodenschichten demselben elektrischen Pol des Bauelements zugeordnet sind. Dann können keine nennenswerten elektrischen Felder mehr über die Sollbruchschicht aufgebaut werden.

In einer Ausführungsform des Bauelements ist die Porosität der Sollbruchschichten gegenüber den keramischen Schichten um einen Faktor zwischen 1,2 und 3 erhöht. Diese Angabe der Porosität bezieht sich auf die folgende Methode zur Messung der Porosität:

Es wird das Bauelement in einem Längsschliff betrachtet. Poren, die sowohl in den keramischen Schichten als auch in den Sollbruchschichten auftreten können, unterscheiden sich durch einen farblichen bzw. Hell-Dunkel-Kontrast von dem sie umgebenden Keramikmaterial. Nun wird für jede Art von Schicht, also für die keramische Schicht und für eine Sollbruchschicht über eine Einheitsfläche der Flächenanteil der Poren an dieser Einheitsfläche ermittelt. Der Quotient aus den beiden Flächenanteilen der Poren ergibt den Faktor der erhöhten Porosität.

Die Porosität kann auch als Bruchteil der theoretisch möglichen Dichte angegeben werden. In diesem Fall hätten die keramischen Schichten eine Dichte von ca. 97-98 % der theoretischen Dichte und die Sollbruchschichten eine Dichte von 90-95 % der theoretische Dichte.

Es ist des weiteren vorteilhaft, wenn die Sollbruchschichten aus demselben Keramikmaterial bestehen, wie die keramischen Schichten. Dadurch kann die Materialvielfalt des Bauelements in vorteilhafter Weise reduziert werden, was zudem noch den positiven Nebeneffekt hat, daß die weiteren Prozesse zur Herstellung des Bauelements, wie beispielsweise Entbindern und Sintern einfacher durchführbar sind.

Es ist darüber hinaus besonders vorteilhaft, wenn das elektrische Vielschichtbauelement ein piezoelektrischer Aktor ist. Bei einem piezoelektrischen Aktor ist die vorliegende Erfindung besonders vorteilhaft einsetzbar, da ein piezoelektrischer Aktor beim Betrieb Zugspannungen an einer Grenzfläche zwischen einer aktiven und einer passiven Zone erzeugt, welche mittels der Sollbruchschichten definiert ins Innere des Aktors geleitet werden können, wodurch ein Reißen der Innenelektroden vermieden werden kann.

Es wird darüber hinaus ein Schichtstapel angegeben, der zur Herstellung des hier beschriebenen Vielschichtbauelements geeignet ist. Ein solcher Schichtstapel enthält übereinandergestapelte keramische Grünfolien, welche ein Keramikpulver und ein organisches Bindemittel enthalten. Wenigstens eine der Grünfolien weist einen gegenüber den übrigen Grünfolien erhöhten Volumenanteil an Bindemittel auf.

Der hier angegebene Schichtstapel hat den Vorteil, daß durch den erhöhten Volumenanteil an Bindemittel in einer oder mehrerer der Grünfolien in dem Schichtstapel die Herstellung von keramischen Schichten mit einer erhöhten Porosität möglich ist. Das Bindemittel wird nämlich noch vor dem Sintern durch einen Entkohlungsprozeß entfernt und an den Stellen in den Schichten, in denen der hohe Anteil von Bindemittel vorhanden war, können sich anschließend Poren bilden.

Dabei ist es besonders vorteilhaft, wenn der Volumenanteil an Bindemittel um einen Faktor zwischen 1,5 und 3 erhöht ist. Dadurch kann die Gefahr vermindert werden, daß in der Keramikschicht zu wenig Keramikpulver vorhanden ist, so daß nach dem Sintern kein monolithisches Bauelement, sondern ein bereits vor dem elektrischen Betrieb in einzelne Teil-Bauelemente unterteiltes Bauelement resultiert.

Im folgenden wird die Erfindung anhand eines Ausführungsbeispiels und den dazugehörigen Figuren näher erläutert.
- Figur 1: zeigt beispielhaft ein erfindungsgemäßes Viel- schichtbauelement in einer perspektivischen An- sicht.
- Figur 2: zeigt einen Längsschnitt eines Teilbereichs des Bauelements aus Figur 1.

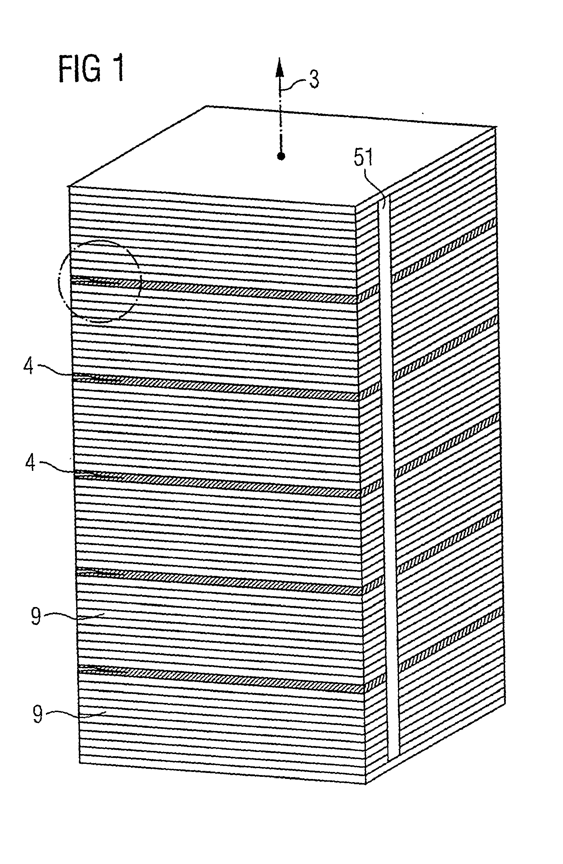

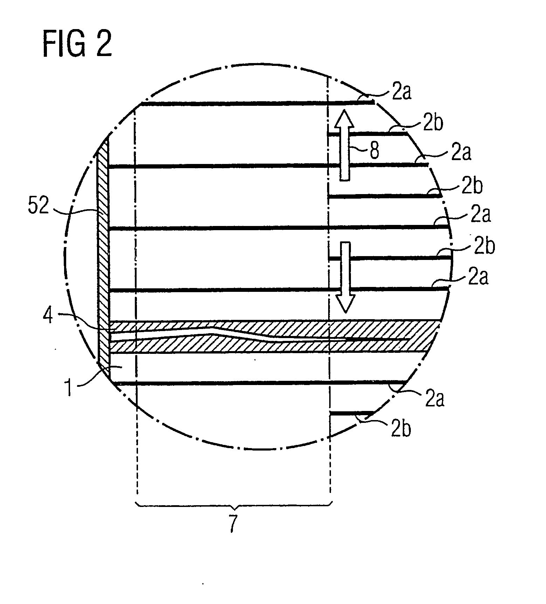

Die Figuren 1 und 2 zeigen einen piezoelektrischen Aktor, bei dem eine Vielzahl von keramischen Schichten 1 entlang einer Längsachse 3 übereinandergestapelt sind. Als Keramikmaterial für die keramischen Schichten 1 kann insbesondere eine PZT-Keramik, beispielsweise der Zusammensetzung Pb_{0,96}Cu_{0,02}Nd_{0,02}(Zr_{0,54}Ti_{0,46})O₃·verwendet werden.

Daneben sind Elektrodenschichten 2a, 2b vorgesehen, die jeweils zwischen zwei benachbarten keramischen Schichten 1 angeordnet sind. Dabei gehören die Elektrodenschichten 2a zu einem elektrischen Pol des Bauelements und die Elektrodenschichten 2b zum anderen Pol des elektrischen Bauelements. Die bis ganz an den rechten Rand des Bauelements herangeführten Elektrodenschichten 2b sind durch die Außenkontaktierung 51 miteinander elektrisch leitend verbunden und gleichzeitig ermöglicht die Außenkontaktierung 51 das Anlegen eines Pols einer elektrischen Spannungsquelle.

Dementsprechend sind die auf der linken Seite des Bauelements bis an den äußeren Rand reichenden Elektrodenschichten 2a mit einer auf der linken Seite des Bauelements (nicht in Figur 1 sichtbar) angeordneten Außenkontaktierung 52 elektrisch leitend verbunden. An die Außenkontaktierung 52 kann der andere Pol der elektrischen Spannungsquelle angeschlossen werden.

Im Gebiet einer passiven Zone 7 überlappen die Elektrodenschichten 2a und 2b einander nicht, sondern es sind lediglich Elektrodenschichten einer einzigen Sorte, beispielsweise Elektrodenschichten 2a (vgl. Figur 2) in der passiven Zone 7 vorhanden. Um die am inneren Rand der passiven Zone 7 auftretenden Zugspannungen, angedeutet durch die Pfeile 8, vor einem unkontrollierten Wandern in das Innere des Piezoaktors zu hindern, sind über die Längsachse 3 des Piezoaktors verteilte Sollbruchschichten 4 vorgesehen, bei denen die Porosität gegenüber den keramischen Schichten 1 erhöht ist. Entlang der in den Sollbruchschichten 4 vorhandenen Poren können sich Risse 6 besonders gut ausbreiten, was zu einer gewissen Kanalisierung oder Führung der Risse 6 entlang der Sollbruchschichten 4 führt. Dementsprechend kann die Gefahr vermindert werden, daß ein Riß 6, sobald er in einer Sollbruchschicht, wie er das vorzugsweise tun wird, entsteht, nach oben oder nach unten abbiegt, um eine der Elektrodenschichten 2a oder 2b durch Bruch zu verletzen.

Um die Sollbruchschichten 4 möglichst feldfrei auch bei Betrieb des Piezoaktors zu halten, ist es vorgesehen, wie in Figur 2 dargestellt, die unmittelbar zur Sollbruchschicht 4 benachbarten Elektrodenschichten 2a ein und demselben elektrischen Pol des Piezoaktors zuzuordnen.

Die Verteilung der Sollbruchschichten 4 entlang der Längsachse 3 ist dabei so vorzunehmen, daß Teilaktoren 9 entstehen, deren Höhe so stark reduziert ist, daß die bei dem normalen Betrieb bzw. beim Polen des Piezoaktors auftretenden Zugspannungen keine Risse mehr in dem Aktor erzeugen können.

Beispielsweise kann es bei einem 30 mm hohen Piezoaktor vorgesehen sein, diesen durch 9 Sollbruchschichten 4 in 10 Teilaktoren 9 zu unterteilen, wobei jeder Teilaktor eine Höhe von 3 mm aufweist. Diese Höhe von 3 mm entspricht in einem Ausführungsbeispiel der Erfindung einer Anzahl von 37 keramischen Schichten 1.

Als Material der Elektrodenschichten 2a, 2b kommt beispielsweise eine Mischung aus Silber und Palladium, wie sie zur Gemeinsamsinterung mit piezoaktiven Keramikschichten geeignet ist, in Betracht. Darüber hinaus kommen aber auch Elektrodenschichten 2a, 2b in Betracht, welche Kupfer enthalten oder sogar ganz aus Kupfer bestehen.

Die Herstellung des in den Figuren 1 und 2 dargestellten Piezoaktors kann mittels eines Schichtstapels erfolgen, dessen Aussehen dem in den Figuren 1 und 2 dargestellten Bauelement im wesentlichen gleicht, wobei jedoch noch keine Außenkontaktierungen 51, 52 und noch kein Riß 6 vorhanden sind. Im übrigen entspricht der Aufbau der keramischen Schichten, der Elektrodenschichten und der Sollbruchschichten dem Aufbau eines Schichtstapels, wobei die keramischen Schichten in einer Vorform als keramische Grünfolien enthaltend ein Keramikpulver und einen organischen Binder ausgeführt sind. Die Elektrodenschichten sind als metallpulverhaltige Pasten ausgeführt. Die Sollbruchschichten sind wie die keramischen Schichten als Grünfolien ausgeführt, wobei jedoch der Anteil an organischem Binder in den später zu den Sollbruchschichten zu verarbeitenden Schichten gegenüber den übrigen keramischen Schichten erhöht ist. Beispielsweise können für die keramischen Schichten Grünfolien verwendet werden, bei denen ein Volumenanteil von 30 % von dem organischen Binder beansprucht wird. Um den Volumenanteil in bestimmten Schichten des Schichtstapels zu erhöhen, kann dieser auf einen Volumenanteil von 50 bis 60 % erhöht werden. Bei einem solchen Volumenanteil an organischem Binder bekommt man auch noch keine Probleme beim Folienziehen im Hinblick darauf, daß das Keramikpulver agglomeriert und keine definierten Folien mehr gezogen werden können.

Das Bauelement wird durch gemeinsames Sintern der in dem Schichtstapel befindlichen Schichten hergestellt. Dies geschieht in einem einzigen Prozeßschritt.

Es wird abschließend darauf hingewiesen, daß das vorstehend beschriebene elektrische Vielschichtbauelement nicht auf das genannte Keramikmaterial beschränkt ist. Es kommen vielmehr alle möglichen Keramikmaterialien in Betracht, die einen piezoelektrischen Effekt zeigen. Darüber hinaus ist das Bauelement auch nicht auf Piezoaktoren beschränkt. Es kommen vielmehr alle möglichen Keramikmaterialien in Betracht, die eine elektrische Funktion ausüben. Insbesondere kann das Bauelement immer dort Verwendung finden, wo es Zugspannungen in Längsrichtung ausgesetzt ist.

### Bezugszeichenliste

- 1: keramische Schicht
- 2a, b: Elektrodenschicht
- 3: Längsachse
- 4: Sollbruchschicht
- 51, 52: Außenkontaktierung
- 6: Riß
- 7: passive Zone
- 8: Zugspannung
- 9: Teilaktor

## Patentansprüche

1. Elektrisches Vielschichtbauelement,
- mit einer Vielzahl von entlang einer Längsachse (3) angeordneten, übereinanderliegenden keramischen Schichten (1),
- mit dazwischenliegenden Elektrodenschichten (2a, 2b),
- wobei wenigstens an einer Stelle der Längsachse (3) zwischen zwei keramischen Schichten (1) eine keramische Sollbruchschicht (4) angeordnet ist, die gegenüber Zugspannungen (8) in Längsrichtung eine geringere Stabilität aufweist als die keramischen Schichten (1),
- wobei die Sollbruchschicht (4) eine höhere Porosität als die keramischen Schichten (1) aufweist.

2. Bauelement nach einem der Ansprüche 1,
das ein durch Sintern hergestelltes monolithisches Bauelement ist.

3. Bauelement nach einem der Ansprüche 1 bis 2,
das an mehreren Stellen der Längsachse (3) Sollbruchschichten (4) aufweist.

4. Bauelement nach einem der Ansprüche 1 bis 3,
bei dem die zu einer Sollbruchschicht (4) unmittelbar benachbarten Elektrodenschichten (2a, 2b) demselben elektrischen Pol des Bauelements zugeordnet sind.

5. Bauelement nach einem der Ansprüche 1 bis 4,
bei dem die Porosität der Sollbruchschichten (4) gegenüber den keramischen Schichten (1) um den Faktor 1,2 bis 3 erhöht ist.

6. Bauelement nach einem der Ansprüche 1 bis 5,
bei dem die Sollbruchschichten (4) aus demselben Keramikmaterial wie die keramischen Schichten (1) bestehen.

7. Bauelement nach einem der Ansprüche 1 bis 6,
das ein piezoelektrischer Aktor ist.

8. Schichtstapel,
- aufweisend übereinandergestapelte keramische Grünfolien, welche ein Keramikpulver und ein organisches Bindemittel enthalten,
- wobei wenigstens eine der Grünfolien einen gegenüber den übrigen Grünfolien erhöhten Volumenanteil an Bindemittel enthält,
- wobei durch die Anordnung der Grünfolien mit erhöhtem Volumenanteil an Bindemittel der Schichtstapel in Teil-Schichtstapel unterteilt ist.

9. Schichtstapel nach Anspruch 8,
- bei dem der Volumenanteil an Bindemittel um einen Faktor 1,5 bis 3 erhöht ist.

## Claims

1. Electrical multilayered component,
- with a plurality of ceramic layers (1) arranged along a longitudinal axis (3) and lying one on top of the other,
- with electrode layers (2a, 2b) lying in between,
- a ceramic breach layer (4), which has a lower stability with respect to tensile stresses (8) in the longitudinal direction than the ceramic layers (1), being arranged between two ceramic layers (1) at least at one point along the longitudinal axis (3),
- the breach layer (4) having a higher porosity than the ceramic layers (1).

2. Component according to Claim 1, which is a monolithic component produced by sintering.

3. Component according to Claim 1 or 2, which has breach layers (4) at a number of points along the longitudinal axis (3).

4. Component according to one of Claims 1 to 3, in which the electrode layers (2a, 2b) that are directly adjacent to a breach layer (4) are assigned to the same electrical pole of the component.

5. Component according to one of Claims 1 to 4, in which the porosity of the breach layers (4) is increased in comparison with the ceramic layers (1) by a factor of 1.2 to 3.

6. Component according to one of Claims 1 to 5, in which the breach layers (4) consist of the same ceramic material as the ceramic layers (1).

7. Component according to one of Claims 1 to 6, which is a piezoelectric actuator.

8. Layer stack,
- comprising green ceramic sheets, which contain a ceramic powder and an organic binder and are stacked one on top of the other,
- at least one of the green sheets containing a proportion by volume of binder that is increased in comparison with the other green sheets,
- the layer stack being divided into partial layer stacks by the arrangement of the green sheets with increased proportion by volume of binder.

9. Layer stack according to Claim 8,
- in which the proportion by volume of binder is increased by a factor of 1.5 to 3.

## Revendications

1. Composant électrique à plusieurs couches,
- comprenant une pluralité de couches (1) en céramique superposées et disposées le long d'un axe (3) longitudinal,
- comprenant des couches (2a, 2b) d'électrodes interposées,
- dans lequel au moins en un point de l'axe (3) longitudinal, il est disposé deux couches (1) en céramique, une couche (4) destinée à se rompre en céramique, qui a, vis-à-vis de contraintes (8) de traction dans la direction longitudinale, une stabilité plus petite que les couches (1) en céramique,
- dans lequel la couche (4) destinée à se rompre a une porosité plus grande que les couches (1) en céramique.

2. Composant suivant la revendication 1,
qui est un composant monolithique produit par frittage.

3. Composant suivant l'une des revendications 1 à 2,
qui a des couches (4) destinées à se rompre en plusieurs points de l'axe (3) longitudinal.

4. Composant suivant l'une des revendications 1 à 3,
dans lequel les couches (2a, 2b) d'électrodes directement voisines d'une couche (4) destinée à se rompre sont associées au même pôle électrique du composant.

5. Composant suivant l'une des revendications 1 à 4,
dans lequel la porosité des couches (4) destinées à se rompre est plus grande que celle des couches (1) en céramique du facteur 1,2 à 3.

6. Composant suivant l'une des revendications 1 à 5,
dans lequel les couches (4) destinées à se rompre sont en le même matériau céramique que les couches (1) en céramique.

7. Composant suivant l'une des revendications 1 à 6,
qui est un actionneur piézoélectrique.

8. Empilement de couches,
- comportant des feuilles crues en céramique empilées les unes sur les autres qui contiennent une poudre de céramique et un liant organique,
- dans lequel au moins l'une des feuilles crues comporte une proportion en volume de liant plus grande que celle des autres feuilles crues,
- dans lequel, par l'agencement des feuilles crues ayant une proportion en volume plus grande de liant, l'empilement de couches est subdivisé en sous-empilements de couches.

9. Empilement de couches suivant la revendication 8,
- dans lequel la proportion en volume de liant est augmentée d'un facteur de 1,5 à 3.
